# EUROPÄISCHE PATENTSCHRIFT

(11) **EP 1 540 735 B1**
(45) Veröffentlichungstag und Bekanntmachung des Hinweises auf die Patenterteilung: **01.11.2017**
(21) Anmeldenummer: 03798138.8
(22) Anmeldetag: 27.08.2003
(51) Int. Cl.: H01L 29/36, H01L 29/06, H01L 29/10, H01L 29/167, H01L 21/30, H01L 21/266, H01L 21/329, H01L 21/336, H01L 21/331, H01L 21/332

(54) **VERFAHREN ZUR HERSTELLUNG EINER VERGRABENEN STOPPZONE IN EINEM HALBLEITERBAUELEMENT UND HALBLEITERBAUELEMENT MIT EINER VERGRABENEN STOPPZONE**
METHOD FOR THE PRODUCTION OF A BURIED STOP ZONE IN A SEMI-CONDUCTOR ELEMENT AND SEMI-CONDUCTOR ELEMENT COMPRISING A BURIED STOP ZONE
PROCEDE DE PRODUCTION D'UNE ZONE D'ARRET ENFOUIE D'UN ELEMENT SEMI-CONDUCTEUR ET ELEMENT SEMI-CONDUCTEUR POURVU D'UNE ZONE D'ARRET ENFOUIE

(30) Priorität: 20.09.2002 DE 10243758
(43) Veröffentlichungstag der Anmeldung: 15.06.2005
(73) Patentinhaber: Infineon Technologies AG, 85579 Neubiberg (DE)
(72) Erfinder: SCHULZE, Hans-Joachim, 85521 Ottobrunn (DE); BARTHELMESS, Reiner, 59494 Soest (DE); MAUDER, Anton, 83059 Kolbermoor (DE); NIEDERNOSTHEIDE, Franz-Josef, 48157 Münster (DE)
(74) Vertreter: Westphal, Mussgnug & Partner Patentanwälte mbB
(86) Internationale Anmeldenummer: PCT/EP2003/009494
(87) Internationale Veröffentlichungsnummer: WO 2004/030103

(56) Entgegenhaltungen:
- EP-A- 0 405 422
- EP-A- 0 497 290
- EP-A- 0 594 049
- EP-A- 1 030 375
- DE-A- 10 207 522
- US-B1- 6 190 970
- SILBER D ET AL: "IMPROVED DYNAMIC PROPERTIES OF GTO-THYRISTORS AND DIODES BY PROTON IMPLANTATION" INTERNATIONAL ELECTRON DEVICES MEETING. WASHINGTON, DEC. 1-4, 1985; TECHNICAL DIGEST IN ELECTRON DEVICE MEETING, 1985, IEEE, NEW YORK, NY, USA, Dezember 1985 (1985-12), Seiten 162-165, XP000195830
- OHMURA Y ET AL: "ELECTRICAL PROPERTIES OF N-TYP SI LAYERS DOPED WITH PROTON BOMBARDMENT INDUCED SHALLOW DONORS" SOLID STATE COMMUNICATIONS, OXFORD, GB, Bd. 11, Nr. 1, 1. Juli 1972 (1972-07-01), Seiten 263-266, XP001156787 ISSN: 0038-1098

## Beschreibung

Die vorliegende Erfindung betrifft ein Halbleiterbauelement, insbesondere ein vertikales Leistungs-Halbleiterbauelement, mit einer dotierten ersten Halbleiterzone eines ersten Leitungstyps, einer sich an die erste Halbleiterzone anschließenden dotierten zweiten Halbleiterzone eines zweiten Leitungstyps, die schwächer als die erste Halbleiterzone dotiert ist, und einer sich an die zweite Halbleiterzone anschließenden dotierten dritten Halbleiterzone, die stärker als die zweite Halbleiterzone dotiert ist.

Eine derartige Halbleiterstruktur ist sowohl bei vertikalen Dioden und vertikalen Transistoren als auch bei Thyristoren vorhanden, wobei die zweite schwächer dotierte Halbleiterzone als Driftstrecke dient, die im Sperrfall des Bauelements den Großteil der zwischen der ersten und dritten Halbleiterzone anliegenden Spannung aufnimmt.

Bei Dioden ist die dritte Halbleiterzone vom gleichen Leitungstyp wie die zweite Halbleiterzone. Üblicherweise sind die zweite Halbleiterzone und die dritte Halbleiterzone n-dotiert, so dass die erste Halbleiterzone die Anode und die zweite Halbleiterzone die Kathode bildet.

Bei Leistungs-MOS-Transistoren ist im Allgemeinen im Bereich der ersten Halbleiterzone, die üblicherweise im Bereich der Vorderseite eines Halbleiterkörpers liegt, eine Feldeffektstruktur vorhanden, die eine in der ersten Halbleiterzone angeordnete Zone des zweiten, zu der Dotierung der ersten Halbleiterzone komplementären Leitungstyps und eine Steuerelektrode umfasst. Die erste Halbleiterzone bildet die sogenannte Body-Zone des Bauelements, die in der Body-Zone angeordnete komplementär dotierte Zone bildet die Source-Zone oder Emitter-Zone. Die Steuerelektrode bzw. Gate-Elektrode erstreckt sich isoliert gegenüber den Halbleiterzonen von der Source- bzw. Emitter-Zone bis zu der zweiten Halbleiterzone, der Driftzone. Die Source-Zone bzw. die Emitter-Zone und die erste Halbleiterzone sind üblicherweise kurzgeschlossen, so dass parallel zu dem Leistungstransistor eine Freilaufdiode (Body-Diode) geschaltet ist.

Ist der Leistungstransistor als MOSFET (Metal Oxide Field-Effect-Transistor) ausgebildet, so ist die dritte Halbleiterzone vom selben Leitungstyp wie die zweite Halbleiterzone bzw. die Driftzone und bildet die Drain-Zone des Bauelements.

Ist der Leistungstransistor als IGBT (Insulated Gate Bipolar Transistor) oder als Thyristor ausgebildet, so ist die dritte Halbleiterzone komplementär zu der zweiten Halbleiterzone dotiert und bildet die Kollektorzone des Halbleiterbauelements. Bei Thyristoren schließt sich an die erste Zone eine komplementär dotierte Zone an.

Derartige Dioden, MOSFET, IGBT und Thyristoren sind allgemein bekannt.

Die EP 0405 200 A1 beschreibt beispielsweise einen derartigen IGBT, in dessen Driftzone der Source-Zone eine stark dotierte Zone desselben Leitungstyps wie die Driftzone vorgelagert ist und die bewirken soll, dass Löcher, die von der p-dotierten Drain-Zone in die Driftzone injiziert werden, die Source-Zone nicht erreichen, sondern in dieser stark dotierten Zone, die bei einer Ausführungsform aus mehreren beabstandeten Abschnitten aufgebaut ist, rekombinieren.

Alle der genannten Bauelemente unterliegen dem Problem, dass beim Abschalten des Bauelements, also beim Übergang des Bauelements von einem stromleitenden in einen sperrenden Zustand ein Abreißen des Stromes auftreten kann. Dies bezeichnet einen Vorgang, bei dem der Strom des Bauelements extrem schnell auf sehr geringe Werte absinkt. Da durch die Beschaltung derartiger Bauelemente unvermeidlich parasitäre Induktivitäten vorhanden sind, insbesondere in den Zuleitungen, und die Spannung in diesen Induktivitäten bekanntlich proportional zu der Ableitung des Stromes ist, bewirkt eine schnelle Abnahme des Stromes auf sehr geringe Werte eine hohe induzierte Spannung, die zu einer Beschädigung des Bauelements führen kann. Darüber hinaus kann für bestimmte Anwendungen das Auftreten abrupter Stromänderungen unerwünscht sein, beispielsweise bei Verwendung einer Diode als Freilaufdiode in einem Halbleiterbauelement.

Ein sehr schnelles Absinken des Stromes bei Sperren des Bauelements resultiert daraus, dass die zweite Halbleiterzone zunächst noch von Ladungsträgern überflutet ist, die aufgrund einer sich ausgehend von dem pn-Übergang zwischen der ersten und zweiten Halbleiterzone ausbreitenden Raumladungszone aus der zweiten Halbleiterzone der Driftzone abtransportiert werden. Solange dieser Abtransport der "gespeicherten" Ladungsträger (Plasmaladung) anhält, fließt noch ein Strom durch die Anschlussleitungen bzw. zu angeschlossenen Verbrauchern, der langsam abnimmt. Sobald die Raumladungszone den gesamten Halbleiterkörper einnimmt und keine freien Ladungsträger mehr vorhanden sind, sinkt dieser Strom mit einem großen zeitlichen Gradienten auf sehr kleine Werte ab.

Zur Umgehung dieses Problems ist es bekannt, die Abmessungen der zweiten Halbleiterzone in vertikaler Richtung des Halbleiterbauelements möglichst groß zu machen, so dass beim Abschalten möglichst lange Ladungsträger nachgeliefert werden, um ein "weiches" Abschalten, d. h. ein möglichst langsames Abklingen des Stromes, zu gewährleisten. Nachteilig ist hierbei, dass die Verluste zunehmen, da mit zunehmender Dicke der Driftzone auch der Durchlasswiderstand zunimmt.

In der noch nicht veröffentlichten DE 102 14 176.2 ist zur Erzielung eines weichen Abschaltverhaltens eine abschnittsweise ausgebildete Stoppzone vorgeschlagen, die in lateraler Richtung des Halbleiterkörpers beabstandet zueinander angeordnete stärker dotierte Zonen aufweist.

In Silber D. et al. "IMPROVED DYNAMIC PROPERTIES OF GTO-THYRISTORS AND DIODES BY PROTONIMPLANTATION", International Electron Devices Meeting, Washington, December 1-4, 1985, Seiten 162-165 ist ein Verfahren zur Herstellung n-dotierter Halbleiterzonen mittels Protonenimplantation und einem nachfolgenden Temperschritt beschrieben.

Die DE 102 07 522 A1 beschreibt eine PIN-Diode mit einer in einer Driftschicht angeordneten n-leitenden Pufferschicht, die mehrere dotierte Abschnitte aufweist.

Die EP 0 594 049 A1 beschreibt einen IGBT mit beabstandet zueinander angeordneten n-dotierten Halbleiterzonen, die sich entweder unmittelbar an einen p-Emitter anschließen oder die sich an eine n-dotierte Halbleiterzone anschließen, die sich unmittelbar an den p-dotierten Emitter anschließt und die höher dotiert ist als eine n-Basis des IGBT.

Ziel der vorliegenden Erfindung ist es, ein verbessertes Verfahren zur Herstellung eines solchen Halbleiterbauelements mit einer abschnittsweise ausgebildeten Stoppzone und ein mittels eines solchen Verfahrens hergestelltes Halbleiterbauelement zur Verfügung zu stellen.

Diese Ziele werden durch ein Verfahren gemäß der Merkmale des Anspruchs 1 und ein Halbleiterbauelement gemäß der Merkmale des Anspruchs 6 gelöst. Vorteilhafte Ausgestaltungen der Erfindung sind Gegenstand der Unteransprüche.

Das erfindungsgemäße Verfahren zum Herstellen einer Stoppzone in einer dotierten Zone eines Halbleiterkörpers, der eine erste Seite und eine zweite Seite aufweist, umfasst das Aufbringen einer Aussparungen aufweisenden Maske auf eine der Seiten des Halbleiterkörpers, das Bestrahlen der die Maske aufweisenden Seite mit einer Protonenstrahlung und das Durchführen eines Temperverfahrens.

Durch das Verfahren mit der Protonenbestrahlung und der anschließenden Temperung entstehen in den bestrahlten Bereichen wasserstoffinduzierte Donatoren, die sich aus den bestrahlungsbedingten Defekten und den implantierten Wasserstoffatomen ergeben. Der Wasserstoff selbst ist nicht dotierend.

Die Position der einzelnen Abschnitte der Stoppzone in lateraler Richtung des Halbleiterkörpers in dem dotierten Halbleiterbereich ist bestimmt durch die Abmessungen der Maske bzw. der Aussparungen in der Maske, die den Bestrahlungsvorgang maskiert. Die Position dieser Stoppzonen in vertikaler Richtung des Halbleiterkörpers ist bestimmt durch die Eindringtiefe der Protonen in den Halbleiterkörper, die wiederum von der Bestrahlungsenergie abhängig ist. Mittels einer solchen Protonenstrahlung lassen sich dotierte Zonen in Tiefen bis zu einigen hundert *µ*m ausgehend von der bestrahlten Seite des Halbleiterkörpers erzeugen.

Vorzugsweise sind die Temperatur und die Dauer des Temperverfahrens so gewählt, dass durch die Bestrahlung erzeugte Bestrahlungsschäden, die die Trägerlebensdauer reduzieren, zumindest teilweise ausgeheilt werden. Über die Bestrahlungsenergie lässt sich die vertikale Position der Bereiche, in die Protonen eingebracht werden, vergleichsweise exakt einstellen. Durch die Wahl des Temperverfahrens lassen sich gut abgegrenzte dotierte Zonen, die die Abschnitte der Stoppzone bilden, erzeugen.

Als Temperverfahren eignen sich sowohl ein RTA-Verfahren (RTA = Rapid Thermal Annealing) als auch kontinuierliche Ofenprozesse.

Die Temperatur während des Temperverfahrens liegt zwischen 250°C und 550°C, vorzugsweise zwischen 400°C und 500°C. Die Dauer beträgt zwischen 1 min und 250 min.

Die Maske für die partielle Protonenbestrahlung kann eine fest auf eine der Seiten des Halbleiterkörpers aufgebrachte Maske sein. Die Maske kann auch eine Metallblende sein, die vor der zu bestrahlenden Seite des Halbleiterkörpers oder des Wafers, der eine Vielzahl zusammenhängender Halbleiterbauelemente aufweist, positioniert wird.

Das erfindungsgemäße Halbleiterbauelement umfasst eine dotierte erste Halbleiterzone eines ersten Leitungstyps, eine sich an die erste Halbleiterzone anschließende dotierte zweite Halbleiterzone eines zweiten Leitungstyps, die schwächer als die erste Halbleiterzone dotiert ist, eine sich an die zweite Halbleiterzone anschließende dotierte dritte Halbleiterzone, die stärker als die zweite Halbleiterzone dotiert ist, und eine in der zweiten Halbleiterzone beabstandet zu der dritten Halbleiterzone angeordnete Stoppzone des zweiten Leitungstyps, wobei die Stoppzone stärker als die Stoppzone umgebende Bereiche der zweiten Halbleiterzone dotiert ist, und wobei der Abstand zwischen der Stoppzone und der dritten Halbleiterzone geringer als der Abstand zwischen der Stoppzone und der ersten Halbleiterzone ist. Die Stoppzone ist dabei derart abschnittsweise ausgebildet, dass sie eine Anzahl in lateraler Richtung des Halbleiterkörpers beabstandet zueinander angeordnete dotierte Zonen umfasst, wobei diese dotierten Zonen wasserstoffinduzierte Donatoren enthalten. Zwischen den lateral beabstandet zueinander angeordneten Zonen der Stoppzone sind schwächer dotierte Zonen der zweiten Halbleiterzone angeordnet.-Diese schwächer dotierten Zonen der zweiten Halbleiterzone bilden "Durchlässe" für Ladungsträger in der zweiten Halbleiterzone.

Beim Sperren des erfindungsgemäßen Halbleiterbauelements werden, wenn die Raumladungszone die Stoppzone erreicht, aus der stärker dotierten Stoppzone und vor allem aus dem Bereich, der zwischen der Stoppzone und der dritten Zone liegt, Ladungsträger nachgeliefert, die so noch für eine längere Zeitdauer einen Stromfluss hervorrufen als dies ohne Stoppzone der Fall wäre und dadurch ein "weiches" Abschaltverhalten bewirken.

Die Stoppzone erhöht den Durchlasswiderstand nicht wesentlich und ist insbesondere bei solchen Bauelementen vorteilhaft, die zur Erreichung einer guten Höhenstrahlungsfestigkeit eine geringe Dotierung der zweiten Halbleiterzone bzw. der Driftzone besitzen.

Die Stoppzone ist in etwa dort in der zweiten Halbleiterzone angeordnet, wo im Bauelement ohne Stoppzone zum Ende der Ausräumphase freie Ladungsträger - die ausgehend von dem pn-Übergang zwischen der ersten und zweiten Halbleiterzone ausgeräumt werden - vorhanden sind. Dies hängt implizit mit der Position der Stoppzone zusammen. Die Stoppzone liegt näher an der dritten Halbleiterzone als an der ersten Halbleiterzone, das heißt, der Abstand zwischen der Stoppzone und der dritten Halbleiterzone ist geringer als der Abstand zwischen der Stoppzone und der ersten Halbleiterzone.

Vorzugsweise ist der Abstand zwischen der dritten Halbleiterzone und der ersten Halbleiterzone mehr als dreimal so groß wie der Abstand zwischen der Stoppzone und der dritten Halbleiterzone. Die Abmessungen der Stoppzone sind in einer Richtung von der ersten zu der dritten Halbleiterzone, also in vertikaler Richtung des Bauelements, wesentlich geringer als die Abmessungen der zweiten Halbleiterzone in dieser Richtung.

Das Halbleiterbauelement kann als Diode ausgebildet sein, wobei bei einer p-dotierten, ersten Halbleiterzone diese erste Halbleiterzone die Anode bildet und die dritte Halbleiterzone, die dann n-dotiert ist, die Kathode bildet.

Das Halbleiterbauelement kann auch als MOS-Transistor ausgebildet sein, wobei dann wenigstens eine Feldeffektstruktur vorhanden ist, die eine in der ersten Halbleiterzone beabstandet zu der zweiten Halbleiterzone angeordnete Zone des zweiten Leitungstyps und eine isoliert gegenüber den Halbleiterzonen ausgebildete Steuerelektrode umfasst.

Die erste Halbleiterzone bildet dabei die Body-Zone, und die in der Body-Zone angeordnete Zone des zweiten Leitungstyps bildet die Source-Zone bzw. die Emitter-Zone. Der Dotierungstyp der dritten Halbleiterzone entspricht bei einem MOSFET dem Dotierungstyp der zweiten Halbleiterzone bzw. der Driftzone, wobei die dritte Halbleiterzone die Drainzone des MOSFET bildet. Der Dotierungstyp der dritten Halbleiterzone ist bei einem IGBT komplementär zu dem Dotierungstyp der zweiten Halbleiterzone bzw. der Driftzone, wobei die dritte Halbleiterzone die Kollektorzone des IGBT bildet.

Des weiteren kann das Bauelement selbstverständlich auch als Thyristor ausgebildet sein.

Die vorliegende Erfindung wird nachfolgend in Ausführungsbeispielen anhand von Figuren näher erläutert. In den Figuren zeigt
- Figur 1:: ein als Diode ausgebildetes erfindungsgemäßes Halbleiterbauelement,
- Figur 2:: ein als MOSFET ausgebildetes erfindungsgemäßes Halbleiterbauelement,
- Figur 3:: ein als IGBT ausgebildetes erfindungsgemäßes Halbleiterbauelement,
- Figur 4:: beispielhaft einen Dotierungsverlauf in der Stoppzone entlang der in den Figuren 1 bis 3 eingezeichneten Schnittlinie A-A',
- Figur 5:: einen Teilabschnitt eines als Diode ausgebildeten erfindungsgemäßen Halbleiterbauelementes (Figur 5a) und den dreidimensionalen Dotierungsverlauf im Bereich der Stoppzone (Figur 5b),
- Figur 6:: einen Verfahrensschritt zur Herstellung einer vergrabenen Stoppzone in einem Halbleiterbauelement.

In den Figuren bezeichnen, sofern nicht anders angegeben, gleiche Bezugszeichen gleiche Teile und Bereiche mit gleicher Bedeutung.

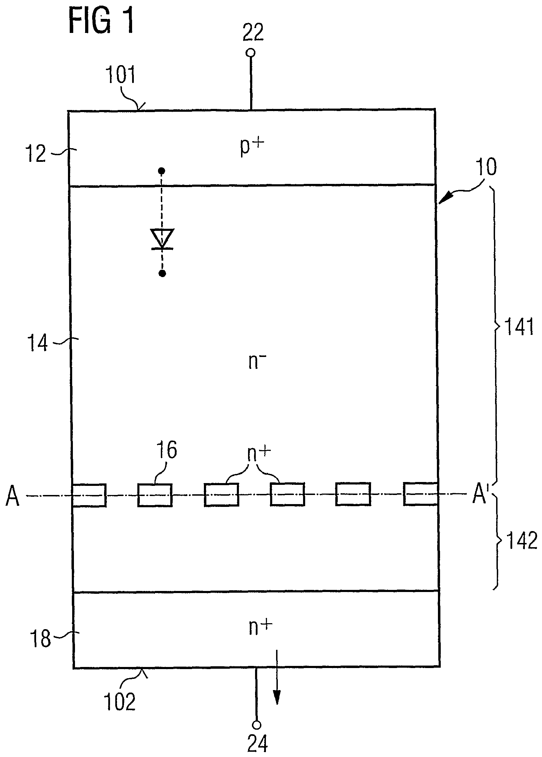

Figur 1 zeigt den Ausschnitt eines Halbleiterkörper 10 eines als Diode ausgebildeten erfindungsgemäßen vertikalen Halbleiterbauelements. Das Bauelement weist eine p-dotierte erste Halbleiterzone 12 auf, die im Bereich der Vorderseite 101 des Halbleiterkörpers 10 angeordnet ist und an die sich in vertikaler Richtung eine schwach n-dotierte zweite Halbleiterzone 14 anschließt. An diese zweite Halbleiterzone 14 schließt sich in vertikaler Richtung eine stark n-dotierte dritte Halbleiterzone 18 an, die die Rückseite 102 des Halbleiterkörpers 10 bildet.

Erfindungsgemäß ist in der zweiten Halbleiterzone 14 beabstandet zu der dritten Halbleiterzone 18 eine stärker als der übrige Bereich der zweiten Halbleiterzone 14 dotierte Stoppzone 16 vorhanden, die vom selben Leitungstyp wie der übrige Bereich der zweiten Halbleiterzone 14 ist. Die Stoppzone 16 ist-beabstandet zu der dritten Halbleiterzone 18 und beabstandet zu der ersten Halbleiterzone 12 angeordnet, wobei der Abstand zwischen der Stoppzone 16 und der dritten Halbleiterzone 18 geringer ist als der Abstand zwischen der Stoppzone 16 und der ersten Halbleiterzone 12 ist.

Die Stoppzone 16 umfasst mehrere Teilabschnitte, die in lateraler Richtung des Bauelements beabstandet zueinander angeordnet sind, so dass zwischen den einzelnen stark n-dotierten Teilzonen schwächer n-dotierte Zonen der zweiten Halbleiterzone 14 vorhanden sind, die Durchlässe für Ladungsträger bilden.

Außerdem ist die Stoppzone n-dotiert, wobei diese n-Dotierung wenigstens teilweise durch wasserstoffinduzierte Donatoren gebildet ist.

Bei dem als PIN-Diode ausgebildeten Bauelement gemäß Figur 1 dient die erste Halbleiterzone 12 als Anodenzone, ein nur schematisch eingezeichneter Anschluss 22 bildet entsprechend den Anodenanschluss. Die zweite Halbleiterzone 14 dient als Driftstrecke oder Driftzone, die im Sperrfall einen wesentlichen Teil der anliegenden Sperrspannung aufnimmt, und die dritte Halbleiterzone 18, die bei der Diode vom selben Leitungstyp wie die Driftstrecke 14 aber komplementär zu der Dotierung der ersten Halbleiterzone 12 ist, dient als Kathodenzone, ein nur schematisch eingezeichneter Anschluss 24 dient entsprechend als Kathodenanschluss. Das elektrische Ersatzschaltbild des Bauelements ist gestrichelt in die Struktur in Figur 1 eingezeichnet.

Die Funktionsweise des erfindungsgemäßen Bauelements und insbesondere die Funktionsweise der Stoppzone 16 wird nachfolgend kurz erläutert.

Bei Anlegen einer positiven Spannung zwischen dem Anodenanschluss 22 und dem Kathodenanschluss 24 wird das Bauelement in Flussrichtung betrieben, wobei Elektronen und Löcher in die Driftzone 14 injiziert werden und diese "überfluten". Das Bauelement sperrt bei einem Umpolen der Spannung, d. h. bei Anlegen einer positiven Spannung zwischen dem Kathodenanschluss 24 und dem Anodenanschluss 22. Ausgehend von der Anodenzone 12 und der Kathodenzone 18 breitet sich dabei eine Raumladungszone aus, die ein Abfließen der freien Ladungsträger aus der Driftzone 14 bewirkt. Diese in der Driftzone 14 noch vorhandenen freien Ladungsträger sorgen dafür, dass der an den Anschlussklemmen 22, 24 zu beobachtende Strom nicht abrupt mit dem Umpolen der Spannung abbricht, sondern noch für eine gewisse Zeitdauer aufrecht erhalten wird, bis die freien Ladungsträger aus der Driftzone 14 abgeflossen sind.

Die Stoppzone 16 ist so angeordnet, dass bei Ausbreiten der Raumladungszone bis zuletzt freie Ladungsträger vorhanden sind, insbesondere in der Zone 142 zwischen der Stoppzone 16 und dem Emitter 18. Bevor das Bauelement vollständig sperrt, d. h. der an den Anschlussklemmen 22, 24 zu beobachtende Strom auf sehr kleine Werte (Sperrstrom) absinkt, werden auch freie Ladungsträger aus der stärker dotierten Stoppzone 16 und der Zone 142 nachgeliefert. Da aus der vorgeschlagenen Struktur mit der Stoppzone 16 mehr Ladungsträger geliefert werden, als bei einem Bauelement, bei dem keine derartige vergrabene Stoppzone vorhanden ist, nimmt der Strom bei dem erfindungsgemäßen Halbleiterbauelement langsamer ab. Insbesondere der Stromabfall kurz bevor die Raumladungszone ihre maximale Ausdehnung erreicht hat, ist bei dem erfindungsgemäßen Halbleiterbauelement geringer als bei herkömmlichen derartigen Bauelementen. Induzierte Spannungen in parasitären Induktivitäten, beispielsweise den Zuleitungen, die proportional zur Ableitung des Stromes sind, sind bei dem erfindungsgemäßen Bauelement gegenüber herkömmlichen derartigen Bauelementen deshalb reduziert.

Die abschnittsweise Ausbildung der Stoppzone 16 mit dazwischen liegenden schwächer dotierten Bereichen sorgt dafür, dass durch die schwächer dotierten Bereiche "Durchlässe" für freie Ladungsträger vorhanden sind, um den Ladungsträgerstrom in der Driftzone 14 durch das Vorhandensein der Stoppzone nicht oder nur unwesentlich zu beeinflussen.

Wie bereits erläutert, ist die Stoppzone in einem Bereich der Driftzone angeordnet, der näher an der n-dotierten dritten Halbleiterzone 18 als an der p-dotierten ersten Halbleiterzone 12 liegt. Der Abstand zwischen der dritten Halbleiterzone 18 und der ersten Halbleiterzone 12 ist vorzugsweise mehr als dreimal so groß wie der Abstand zwischen der Stoppzone 16 und der dritten Halbleiterzone 18.

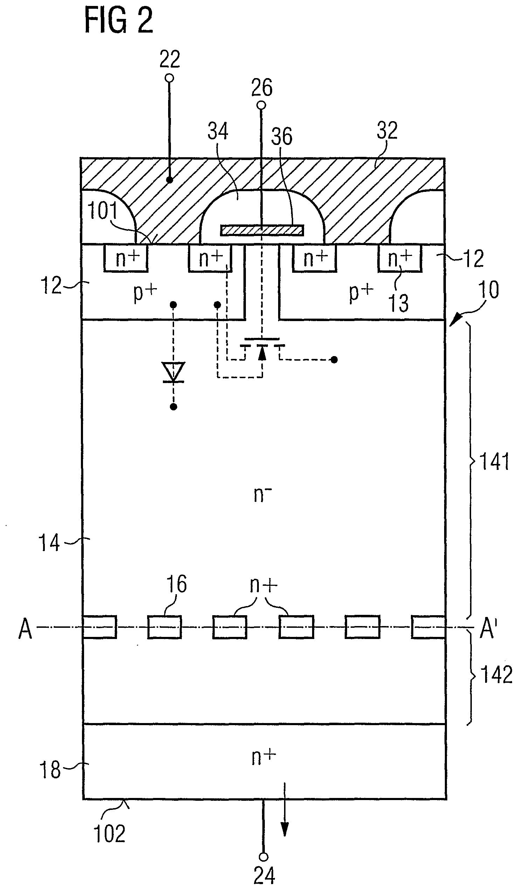

Figur 2 zeigt ein als MOSFET ausgebildetes erfindungsgemäßes Halbleiterbauelement, das sich von der Diode gemäß Figur 1 dadurch unterscheidet, dass im Bereich der Vorderseite des Halbleiterbauelements eine Feldeffektstruktur vorhanden ist. Diese Feldeffektstruktur umfasst stark n-dotierte Source-Zonen 13 in der als Body-Zone dienenden ersten Halbleiterzone 12 sowie wenigstens eine gegenüber dem Halbleiterkörper 10 isolierte Gate-Elektrode 36 zur Ausbildung eines leitenden Kanals zwischen der Source-Zone 13 und der Driftzone 14 bei Anlegen eines geeigneten Ansteuerpotentials. Die Driftzone 14 erstreckt sich bei dem MOSFET abschnittsweise zwischen den stark p-dotierten Body-Zonen 12 bis an die Vorderseite 101 des Halbleiterkörper, oberhalb der die Gate-Elektrode 36 angeordnet ist.

Bei einer alternativen, nicht näher dargestellten Ausbildung des MOSFET als Trench-MOSFET ist die Gate-Elektrode in einem sich in vertikaler Richtung in den Halbleiterkörper hinein erstreckenden Graben angeordnet und erstreckt sich bis in die Driftzone, so dass die Driftzone bei diesem Ausführungsbeispiel nicht bis an die Vorderseite des Halbleiterkörpers 10 reicht.

Die Body-Zone 12 und die Source-Zone 13 sind durch eine Anschlusselektrode 22 kurzgeschlossen, die die Source-Elektrode des Bauelements bildet. Die stark n-dotierte Halbleiterzone 18 im Bereich der Rückseite 102 des Halbleiterbauelements dient als Drain-Anschluss. Die Gate-Elektrode 36 ist durch einen schematisch dargestellten Gate-Anschluss 26 kontaktiert.

Erfindungsgemäß ist auch bei diesem Halbleiterbauelement eine stärker als die zweite Halbleiterzone 14 dotierte Stoppzone 16 vorhanden, die ein "weiches Abschalten" der Body-Diode gewährleistet. Die Funktion dieser Body-Diode entspricht der Funktion der in Figur 1 dargestellten Diode, wobei diese Diode in Flussrichtung gepolt ist, wenn zwischen dem Source-Anschluss und dem Drain-Anschluss des MOSFET eine positive Spannung anliegt. Diese Diode, deren Schaltsymbol gestrichelt eingezeichnet ist, dient als Freilaufdiode, die bei sperrendem MOSFET und Anliegen einer positiven Source-Drain-Spannung leitet. Die spezielle Anordnung der Stoppzone 16 sorgt dafür, dass bei einem Umpolen der Spannung, d. h. einem Anliegen einer positiven Drain-Source-Spannung der durch die Body-Diode fließende Freilaufstrom nicht abrupt abnimmt.

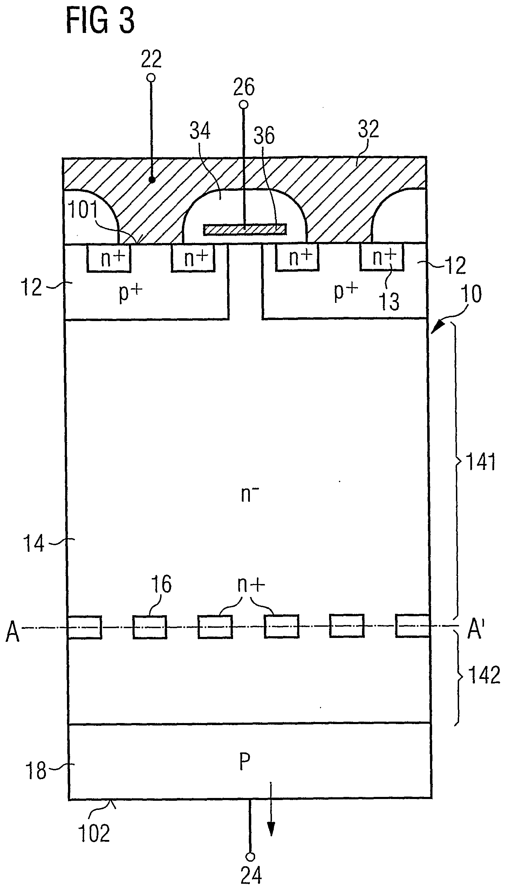

Figur 3 zeigt ein als IGBT ausgebildetes erfindungsgemäßes Halbleiterbauelement, das sich von dem in Figur 2 dargestellten dadurch unterscheidet, dass die dritte Halbleiterzone 18 im Bereich der Rückseite des Halbleiterkörpers 10 p-dotiert ist, um bei leitend angesteuertem Bauelement in bekannter Weise Minoritätsladungsträger in die Driftzone 14 zu injizieren.

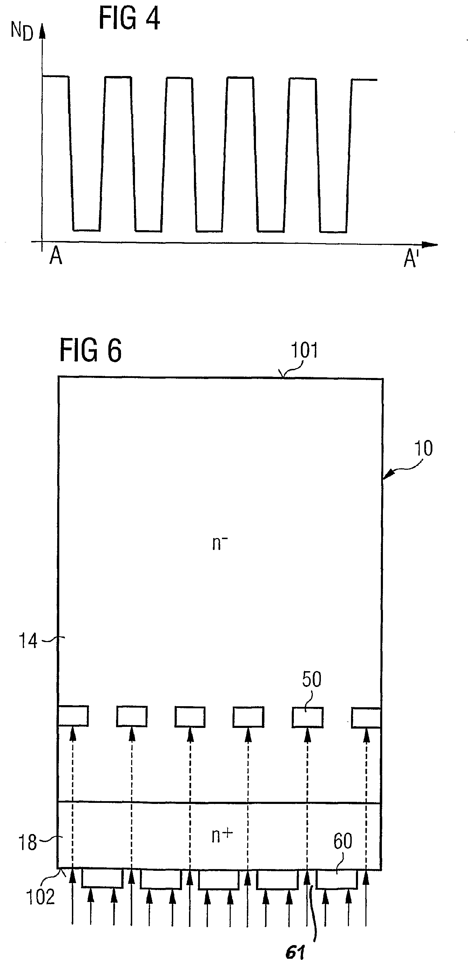

Figur 4 zeigt schematisch den Dotierungsverlauf, d. h. die Konzentration N_{D} an Donatoren entlang der in den Figuren 1 bis 3 eingezeichneten Schnittlinie A-A' im Bereich der Stoppzone 16. Diese Dotierungskonzentration ist im Bereich der Abschnitte der stark dotierten Stoppzone 16 hoch und zwischen diesen Abschnitten entsprechend niedrig. Übliche Werte für die hohe Dotierung betragen etwa 10¹⁶cm⁻³. Übliche Werte für die niedrige Dotierung liegen im Bereich zwischen 10¹²cm⁻³ und 10¹⁴cm⁻³.

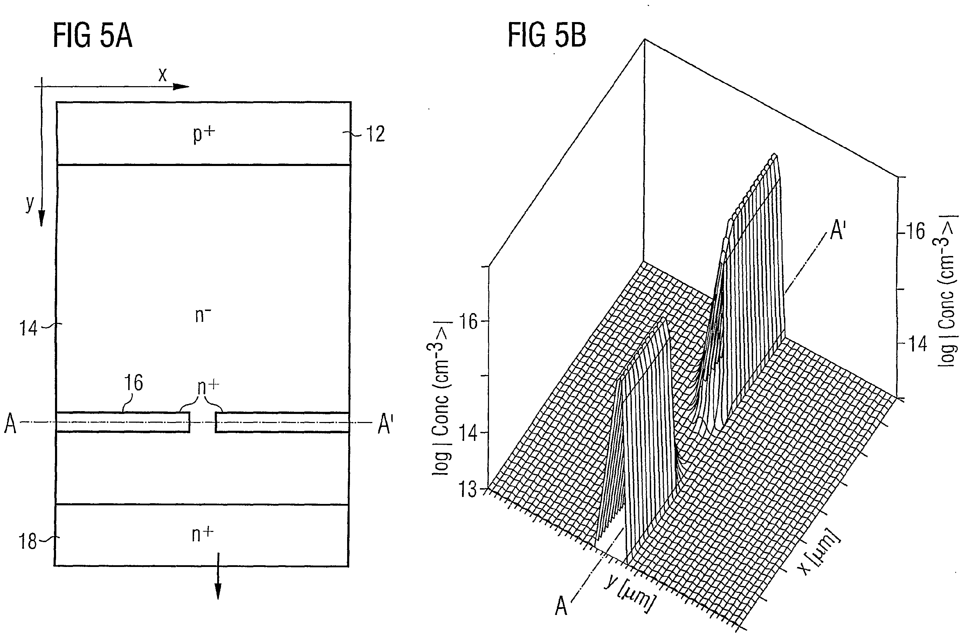

Die Breite der Abschnitte der Stoppzone 16 kann in etwa dem Abstand zwischen diesen Abschnitten entsprechen. Der Abstand zwischen diesen Stoppzonen kann jedoch auch wesentlich geringer als die lateralen Abmessungen der Stoppzonen sein, wie bei der erfindungsgemäßen Diode gemäß Figur 5a dargestellt ist.

Figur 5b zeigt den dreidimensionalen Dotierungsverlauf im Bereich der Stoppzone 16 bei der Diode nach Figur 5a, woraus hervorgeht, dass die Dotierung im Bereich der Stoppzone wesentlich höher ist als die Dotierung umliegender Bereiche. Zur Herstellung der Stoppzone ist vorgesehen, eine Aussparungen 61 aufweisende Maske 60 auf eine der Seiten des Halbleiterkörpers 10, aufzubringen und diese Seite des Halbleiterkörpers mit Protonen zu bestrahlen. Figur 6 veranschaulicht diesen Verfahrensschritt, wobei in Figur 6 die Aussparungen 61 aufweisende Maske 60 auf die Rückseite 102 des Halbleiterkörpers aufgebracht ist. Anstelle der Maske 60 kann auch eine Metallblende verwendet werden, die auf oder vor der Rückseite 102 des Halbleiterkörpers 10 positioniert wird. Der Bestrahlungsvorgang findet in einem Prozessstadium statt, bei dem eine Vielzahl von Halbleiterbauelementen noch gemeinsam in einem Wafer integriert sein können, wobei die Metallblende in geeigneter Weise vor dem Wafer positioniert wird.

Die Energie, mit der die Protonen in den Halbleiterkörper 10 eingestrahlt werden, ist so gewählt, dass die Protonen in vertikaler Richtung bis in die Bereiche vordringen, in denen die einzelnen Abschnitte der Stoppzone gebildet werden sollen. Diese Bereiche, bis in die die eingestrahlten Protonen vordringen sind in Figur 6 mit dem Bezugszeichen 50 bezeichnet.

An die Protonenbestrahlung schließt sich ein Temperverfahren an, wobei die Temperatur und die Dauer dieses Temperverfahrens so gewählt ist, dass Bestrahlungsschäden in den durch die Protonen auf ihrem Weg bis in die Bereiche 50 durchstrahlten Bereich weitgehend ausgeheilt werden, dass jedoch keine wesentliche Diffusion der in die Bereiche 50 eingestrahlten Protonen erfolgt, um möglichst eng begrenzte dotierte Zonen zu erreichen, die die einzelnen Abschnitte der späteren Stoppzone 16 bilden. Die n-Dotierung dieser Stoppzonenabschnitte resultiert aus wasserstoffinduzierten Donatoren, die eingestrahlten Protonen bzw. Wasserstoffionen selbst wirken nicht dotierend.

Die Bestrahlungsenergie, mit der die Protonen in den Halbleiterkörper 10 eingebracht werden, ist so gewählt, dass die Bereiche 50 mit den eingestrahlten Protonen in einem gewünschten Abstand von der stärker dotierten dritten Halbleiterzone 18 liegen.

Durch die Protonenbestrahlung entstehen Kristalldefekte in den durch die Protonen durchstrahlten Bereichen des Halbleiterkörpers. Diese Kristalldefekte führen zu einer Verringerung der Ladungsträgerlebensdauer, was wiederum zu einer Erhöhung der Durchlassspannung des Halbleiterbauelementes führt. Experimente haben gezeigt, dass bei Ausheiltemperaturen im Bereich von 500° C die vor der Bestrahlung vorhandene Ladungsträgerlebensdauer annäherungsweise wieder erreicht wird. Die während des Temperschrittes vorhandenen Temperaturen liegen vorzugsweise deshalb im Bereich zwischen 400°C und 500°C.

## Patentansprüche

1. Verfahren, das aufweist:
Bestrahlen einer (102) von einer ersten Seite (101) und einer zweiten Seite (102) eines Halbleiterkörpers (100) durch eine Aussparungen (61) aufweisende Maske (60) mit einer Protonenstrahlung, deren Energie derart gewählt wird, dass Protonen durch die Aussparungen (61) der Maske (60) in der vertikalen Richtung des Halbleiterkörpers (100) bis in Bereiche vordringen, in denen mehrere in einer lateralen Richtung des Halbleiterkörpers (100) beabstandet zueinander angeordnete Zonen einer Stoppzone (16) gebildet werden sollen,
Durchführen eines Temperverfahrens zur Erzeugung der mehreren in der lateralen Richtung des Halbleiterkörpers (100) beabstandet zueinander angeordneten Zonen der Stoppzone (16) in dem Halbleiterkörper (100),
wobei die Zonen die Stoppzone (16) bilden und wasserstoffinduzierte Donatoren aufweisen,
wobei die Zonen der Stoppzone (16) so hergestellt werden, dass die Stoppzone (16) in einer zweiten Halbleiterzone (14) angeordnet ist, die vom gleichen Leitungstyp wie die Stoppzone (16), jedoch niedriger als die Stoppzone (16) dotiert ist, und dass die Stoppzone (16) in einer vertikalen Richtung des Halbleiterkörpers (100) zwischen einer ersten Halbleiterzone (12) eines zu der Stoppzone (16) komplementären Leitungstyps und einer dritten Halbleiterzone (18), die stärker als die zweite Halbleiterzone dotiert ist, angeordnet ist, und
wobei ein Abstand zwischen der Stoppzone (16) und der ersten Halbleiterzone (12) mehr als dreimal so groß ist wie der Abstand zwischen der Stoppzone (16) und der dritten Halbleiterzone (18).

2. Verfahren nach Anspruch 1, bei dem die Temperatur während des Temperverfahrens zwischen 250 °C und 550 °C beträgt und die Dauer des Temperverfahrens zwischen 1 min und 250 min beträgt.

3. Verfahren nach Anspruch 2, bei dem das Temperverfahren ein RTA-Verfahren ist.

4. Verfahren nach Anspruch 2 oder 3, bei dem die Temperatur während des Temperverfahrens zwischen 400°C und 500°C beträgt.

5. Verfahren nach einem der vorangehenden Ansprüche, bei der die Maske eine Metallblende ist.

6. Halbleiterbauelement, das aufweist:
eine dotierte erste Halbleiterzone (12) eines ersten Leitungstyps (p),
eine sich an die erste Halbleiterzone (12) anschließende dotierte zweite Halbleiterzone (14) eines zweiten Leitungstyps (n), die schwächer als die erste Halbleiterzone (12) dotiert ist,
eine sich an die zweite Halbleiterzone (14) anschließende dotierte dritte Halbleiterzone (18), die stärker als die zweite Halbleiterzone (14) dotiert ist,
eine in der zweiten Halbleiterzone (14) beabstandet zu der dritten (18) Halbleiterzone angeordnete Stoppzone (16) des zweiten Leitungstyps (n), wobei die Stoppzone (16) stärker als die Stoppzone (16) umgebende Bereiche der zweiten Halbleiterzone (14) dotiert ist,
**dadurch gekennzeichnet, dass**
der Abstand zwischen der Stoppzone (16) und der ersten Halbleiterzone (12) mehr als dreimal so groß ist wie der Abstand zwischen der Stoppzone (16) und der dritten Halbleiterzone (18), die Stoppzone (16) in der Weise abschnittsweise ausgebildet ist, dass sie mehrere lateral beabstandet zueinander angeordnete Zonen aufweist und die Dotierung der Stoppzone wenigstens teilweise durch wasserstoffinduzierte Donatoren gebildet ist.

7. Halbleiterbauelement nach Anspruch 6, das wenigstens eine Feldeffektstruktur aufweist, die eine in der ersten Halbleiterzone (12) beabstandet zu der zweiten Halbleiterzone (14) angeordnete Zone (13) des zweiten Leitungstyps (n) und eine isoliert gegenüber den Halbleiterzonen (12, 13) ausgebildete Steuerelektrode (36) umfasst.

8. Halbleiterbauelement nach Anspruch 6 oder 7, bei dem die dritte Halbleiterzone (18) vom zweiten Leitungstyp (n) ist.

9. Halbleiterbauelement nach Anspruch 7, bei dem die dritte Halbleiterzone (18) vom ersten Leitungstyp ist.

10. Halbleiterbauelement nach einem der Ansprüche 6 bis 9, bei dem die Abmessungen der Stoppzone (16) in Richtung von der ersten zu der dritten Halbleiterzone (12, 18) wesentlich geringer als die Abmessungen der zweiten Halbleiterzone (14) in dieser Richtung sind.

## Claims

1. Method, comprising:
irradiating one of a first side (101) and a second side (102) of a semiconductor body (100) through a mask (60) with openings (61) by a proton irradiation the energy of which is selected such that protons through the openings (61) of the mask (60), in the vertical direction of the semiconductor body (100), penetrate into regions in which several zones of a stop zone (16) are to be formed spaced apart from each other in a lateral direction of the semiconductor body (100),
performing an annealing process for producing the several zones of the stop zone (16) that are spaced apart from each other in the lateral direction of the semiconductor body (100) in the semiconductor body (100),
wherein the zones form the stop zone (16) and include hydrogen induced donors,
wherein the zones of the stop zone (16) are formed such that the stop zone (16) is arranged in a second semiconductor zone (16), which is of the same doping type as the stop zone (16), but more lowly doped than the stop zone (16), and that the stop zone (16), in a vertical direction of the semiconductor body (100), is arranged between a first semiconductor zone (12) of a doping type complementary to the stop zone (16) and a third semiconductor zone (18) that is more highly doped than the second semiconductor zone (14), and
wherein a distance between the stop zone (16) and the first semiconductor zone (12) is more than three times the distance between the stop zone (16) and the third semiconductor zone (18).

2. Method of claim 1, wherein the temperature during the annealing process is between 250°C and 550°C and the duration of the annealing process is between 1 min and 250 min.

3. Method of claim 2, wherein the annealing process is an RTA process.

4. Method of claims 2 or 3, wherein the temperature during the annealing process is between 400°C and 500°C.

5. Method of one of the proceeding claims, wherein the mask is a metal mask.

6. Semiconductor device, comprising:
a doped first semiconductor zone (12) of a first doping type (p),
a doped second semiconductor zone (14) of a second doping type (n) adjoining the first semiconductor zone (12) and being more lowly doped than the first semiconductor zone (12),
a third semiconductor zone (18) adjoining the second semiconductor zone (14) and being more highly doped than the second semiconductor zone (14),
a stop zone (16) of the second doping type (n) arranged in the second semiconductor zone (14) spaced apart from the third semiconductor zone (18), wherein the stop zone (16) is more highly doped than regions of the second semiconductor zone (14) surrounding the stop zone (16),
**characterized in that**,
the distance between the stop zone (16) and the first semiconductor zone (12) is more than three times the distance between the stop zone (16) and the third semiconductor zone (18), the stop zone (16) is formed in sections such that it comprises several zones that are laterally spaced part from each other, and the doping of the stop zone is at least partially formed by hydrogen induced donors.

7. Semiconductor device of claim 6, comprising at least one field effect structure comprising a zone (13) of the second doping type (n) in the first semiconductor zone (12) spaced apart from the second semiconductor zone (14), and a control electrode (36) formed isolated from the semiconductor zones (12, 13).

8. Semiconductor device of claim 6 or 7, wherein the third semiconductor zone (18) is of the second doping type (n).

9. Semiconductor device of claim 7, wherein the third semiconductor zone (18) is of the first doping type.

10. Semiconductor device according to one of claims 6 to 9, wherein the dimensions of the stop zone (16) in the direction of the first and third semiconductor zone (12, 18) is significantly lower than the dimensions of the second semiconductor zone (14) in this direction.

## Revendications

1. Procédé comprenant :
l'irradiation d'une (102) d'une première face (101) et d'une deuxième face (102) d'un corps semi-conducteur (100) à travers un masque (60) comprenant des évidements (61) avec un rayonnement de protons, dont l'énergie est choisie de telle façon que les protons avancent à travers les évidements (61) du masque (60) dans la direction verticale du corps semi-conducteur (100) jusque dans des régions, dans lesquelles plusieurs zones d'une zone d'arrêt (16) arrangées espacées l'une de l'autre dans une direction latérale du corps semi-conducteur (100) doivent être formées,
l'exécution d'un procédé de recuit destiné à produire les différentes zones de la zone d'arrêt (16) arrangées espacées l'une de l'autre dans la direction latérale du corps semi-conducteur (100) dans le corps semi-conducteur (100),
dans lequel les zones forment la zone d'arrêt (16) et comportent des impuretés donatrices induites par l'hydrogène,
dans lequel les zones de la zone d'arrêt (16) sont produites de telle façon que la zone d'arrêt (16) est arrangée dans une deuxième zone semi-conductrice (14), qui est du même type conducteur que la zone d'arrêt (16), cependant plus faiblement dopée que la zone d'arrêt (16), et la zone d'arrêt (16) est arrangée dans une direction verticale du corps semi-conducteur (100) entre une première zone semi-conductrice (12) d'un type conducteur complémentaire de la zone d'arrêt (16) et une troisième zone semi-conductrice (18), qui est plus fortement dotée que la deuxième zone semi-conductrice (14), et
dans lequel une distance entre la zone d'arrêt et la première zone semi-conductrice (12) est plus de trois fois plus grande que la distance entre la zone d'arrêt (16) et la troisième zone semi-conductrice (18).

2. Procédé selon la revendication 1, dans lequel la température durant le procédé de recuit est comprise entre 250 °C et 550 °C et la durée du procédé de recuit est comprise entre 1 min et 250 min.

3. Procédé selon la revendication 2, dans lequel le procédé de recuit est un procédé RTA.

4. Procédé selon l'une des revendications 2 ou 3, dans lequel la température pendant le procédé de recuit est comprise entre 400 °C et 500 °C.

5. Procédé selon l'une des revendications précédentes, dans lequel le masque est un diaphragme métallique.

6. Élément semi-conducteur comprenant :
une première zone semi-conductrice (12) dopée d'un premier type conducteur (p),
une deuxième zone semi-conductrice (14) dopée d'un second type conducteur (n) adjacente à la première zone semi-conductrice (12), qui est plus faiblement dopée que la première zone semi-conductrice (12),
une troisième zone semi-conductrice dopée (18) adjacente à la deuxième zone semi-conductrice (14), qui est plus fortement dopée que la deuxième zone semi-conductrice (14),
une zone d'arrêt (16) du second type conducteur (n) arrangée espacée de la troisième zone semi-conductrice (18) dans la deuxième zone semi-conductrice (14), la zone d'arrêt (16) étant plus fortement dopée que les régions de la deuxième zone semi-conductrice (14) entourant la zone d'arrêt (16), **caractérisé en ce que** la distance entre la zone d'arrêt (16) et la première zone semi-conductrice (12) est plus de trois fois plus grande que la distance entre la zone d'arrêt (16) et la troisième zone semi-conductrice (18), la zone d'arrêt (16) est construite par sections de telle façon qu'elle présente plusieurs zones agencées espacées l'une de l'autre latéralement et le dopage de la zone d'arrêt est formé au moins en partie par des impuretés donatrices induites par l'hydrogène.

7. Élément semi-conducteur selon la revendication 6, comportant au moins une structure d'effet de champ, qui comprend une zone (13) du second type conducteur (n) arrangée espacée de la deuxième zone semi-conductrice (14) dans la première zone semi-conductrice (12) et une électrode de commande (36) formée de manière isolée par rapport aux zones semiconductrices (12, 13).

8. Élément semi-conducteur selon les revendications 6 ou 7, dans lequel la troisième zone semi-conductrice (18) est du second type conducteur (n).

9. Élément semi-conducteur selon la revendication 7, dans lequel la troisième zone semi-conductrice (18) est du premier type conducteur.

10. Élément semi-conducteur selon l'une des revendications 6 à 9, dans lequel les dimensions de la zone d'arrêt (16) en direction de la première à la troisième zone semi-conductrice (12, 18) sont beaucoup plus petites que les dimensions de la deuxième zone semi-conductrice (14) dans cette direction.
